# EUROPEAN PATENT SPECIFICATION

(11) **EP 0 604 801 B1**
(45) Date of publication and mention of the grant of the patent: **06.10.1999**
(21) Application number: 93119798.2
(22) Date of filing: 08.12.1993
(51) Int. Cl.: H01L 31/0336, H01L 31/18

(54) **Method of making a thin film heterojunction solar cell**
Verfahren zum Herstellen einer Dünnschicht-Heteroübergang-Sonnenzelle
Procédé de fabrication d'une cellule solaire à hétérojonction en couche mince

(30) Priority: 30.12.1992 US 998211
(43) Date of publication of application: 06.07.1994
(73) Proprietor: Siemens Solar Industries International, Inc., Camarillo, California 93010 (US)
(72) Inventor: Pollock, Gary A., Woodland Hills, CA 91364 (US); Mitchell, Kim W., Granada Hills, CA 91344 (US)
(74) Representative: Zangs, Rainer E., Dipl.-Ing.

(56) References cited:
- EP-A- 0 206 585
- THIN SOLID FILMS, vol. 149, no. 1, 11 May 1987, LAUSANNE CH, pages 65 - 71 RISTOV ET AL. 'CHEMICAL DEPOSITION OF ZnO FILMS'
- THIN SOLID FILMS, vol. 90, no. 4, April 1982, LAUSANNE CH, pages 419 - 423 TOMAR ET AL. 'A ZnO/p-CuInSe2 THIN FILM SOLAR CELL PREPARED ENTIRELY BY SPRAY PYROLYSIS'
- SOLAR ENERGY MATERIALS, vol. 17, no. 4, June 1988, AMSTERDAM NL, pages 289 - 297 QIU ET AL. 'CHARACTERISTICS OF ZnO/CuInSe2 HETEROJUNCTIONS'

## Description

### FIELD OF THE INVENTION

The invention relates to thin film heterojunction solar cells formed from metal semiconductors, especially to those of the p-n type having a p-type layer comprising group I-III-VI semiconductors such as copper indium diselenide (CIS) and other chalcopyrite alloy materials and to a process for making high efficiency cells of such type.

### BACKGROUND OF THE INVENTION

A known thin film, heterojunction solar cell of such type which was widely regarded as viable, is described in U.S.4,335,226, issued to Mickelsen et al on June 15, 1982 and teaches the provision of a layer of cadmium sulfide (CdS) on an absorber layer of CIS to provide a cell of high efficiency.

Among the many documented attempts to improve such high efficiency cells are U.S. 4,611,091 issued to Choudary et al on September 9, 1986, and U.S. 5,045,409 issued to Eberspacher et al on September 3, 1991.

The Eberspacher patent teaches an improved method of selenization of the CIS semiconductor, while Choudary teaches the replacement of a majority of the cadmium sulfide layer by providing a layer of a transparent, substantially conducting, wide band gap, n-type semiconductor, such as CVD zinc oxide, on only a very thin layer of chemically deposited cadmium sulfide.

In essence, both the last two patents represent responses to the well recognized desirability of minimizing or eliminating the use of highly toxic materials such as hydrogen selenide and cadmium (sulfide) in large scale solar cell manufacturing processes.

The chemically deposited cadmium sulfide approach taught by Choudary resulted in higher quality junctions than those from non-chemical, (non-cadmium) deposition processes in providing lower junction saturation current and increased shunt resistance, such improvement believed to result from an etching and selective "cleaning" action on the heterojunction interface arising from the chemical dipping.

An attempt to eliminate completely the highly toxic cadmium sulfide from the cell by replacement with zinc sulfide (ZnS) deposited from a solution of zinc acetate (ZnAC₂) dissolved in ammonium hydroxide/ ammonium sulfide (NH₄ OH/(NH₄)₂ S) was not successful. Although some zinc hydroxide (Zn(OH)₂), precipitate formed in the solution, no zinc could be detected on CIS dipped in that solution.

However, the discovery some years later, of CIS modules with cadmium sulfide layers chemically deposited from solution having actual thicknesses of less than 10 Å (10 Å = 1 nm) but which, nevertheless, performed effectively, in spite of a belief that a minimum thickness of 100Å was necessary (in the Eberspacher cell) indicated that the cadmium sulfide was in fact acting substantially only as an insulating barrier between the CIS and CVD zinc oxide and that, possibly, relatively non-toxic insulating zinc oxide, or other suitable metal oxides could perform the same function.

EP-A-0 206 585 discloses a thin-film photovoltaic device, in which a molybdenum layer and a copper indium diselenide (CIS) layer are provided on a glass substrate. On top of the CIS layer, a first high-resistivity zinc oxide layer is provided, and thereon, a second low-resistivity zinc oxide layer. The zinc oxide film is deposited by a low-temperature chemical vapor deposition method.

Thin solid films, Vol. 149, No. 1, May 11, 1987, pages 65-71 discloses a method for chemical deposition of ZnO films. According to this method, a zinc salt is mixed with a complexing agent to form a zinc complex in solution, where a ZnO layer is formed on a substrate by decomposition of the zinc complex in boiling water.

### SUMMARY OF THE INVENTION

An object of the invention is to provide another high efficiency, thin film, heterojunction solar cell of the above described type that does not contain cadmium sulfide.

A further object of the invention is to provide a process for making such a solar cell which can be adapted for economical mass production at high volume while minimizing the concentrations or amounts of chemicals used while providing an acceptably high yield.

An additional object of the invention is to provide a solar cell which provides improved open circuit voltage (V_{oc}).

The object of the invention is solved by the process described in claim 1. Advantageous embodiments are contained in the dependent claims.

According to the method of the invention, a thin film photovoltaic devide can be made that comprises a metal back contact; a first multinary semiconductor film of a first conductivity type on said back contact, preferably comprising a group I-III-VI compound semiconductor or other high band gap chalcopyrite alloy material; a second, transparent, semiconductor film of conductivity type opposite said first type on said first semiconductor film, and an interfacial film of a transparent, insulating metal oxide between said first semiconductor film and said second semiconductor film.

More specifically, the second semiconductor film comprises zinc oxide, the first semiconductor film comprises copper indium diselenide (CIS) or alloy thereof and the insulating metal oxide comprises zinc oxide chemically deposited from solution thereon.

According to the method of the invention, a process for making a photovoltaic device basically comprises the steps of depositing a first semiconductor film of a first conductivity type, preferably comprising a group I-III-VI semiconductor or other high band gap chalcopyrite alloy material on a metal back contact; chemically depositing from solution a film of a transparent, insulating metal oxide on said first semiconductor film; and depositing a second, transparent, semiconductor film of conductivity type opposite said first type on said first semiconductor film.

More specifically, the film of transparent, insulating metal oxide is zinc oxide deposited by the steps of mixing one of zinc sulfate, zinc chloride and zinc acetate, preferably zinc acetate, with a suitable complexing agent such as ammonium hydroxide and, preferably triethanolamine (TEA) to dissolve the zinc salt and form a zinc/ammonium (Zn/NH₄) complex in solution; contacting, preferably by dipping, the first semiconductor film with the solution to deposit a thin film of zinc hydroxide from the solution on the first semiconductor film, and annealing the deposited zinc hydroxide film in air for a few minutes to dry and convert the insulating zinc hydroxide to zinc oxide. The zinc hydroxide deposit may be dried in a stream of nitrogen prior to the annealing step.

Preferred solution concentrations are 0.01M ZnAC₂/0.01M TEA/ 0.64M NH₄OH; a dip time/temperature of 55°C/5 minutes and air annealing at 230°C for 10 minutes. A reduction of the concentrations of ZnAC₂ and TEA of up to 50% may still result in sufficient throughput speed with acceptable yields for practical manufacture, while an increase to 0.1M ZnAC₂/0.1M TEA/1.5M NH₄OH should provide somewhat higher yields through decreased reaction times. Further increases of ammonium hydroxide concentration to 3M are feasible while increases in concentrations of ZnAC₂ and TEA to 1M may be possible but the lower concentrations are desirable to avoid using more chemicals than necessary.

Immersion times of between 1 and 5 minutes are effective in forming good cells on test substrates of CIS. Bath temperatures of 55°C and about 20°C both work well. For highest Voc, a 1 min/55°C dip with solution concentrations of 0.01M ZnAC₂/0.01M TEA/ 0.7M NH₄OH is preferred while the highest efficiency is produced under the same operating conditions with a sulfidized CIS.

Furthermore, 0.01M ZnAC₂/0.01M TEA/.7M NH₄OH is preferred to 0.01M ZnSO₄/ 0.7M NH₄OH.

Semiconductor materials of the first film layer may include CIS and other related I-III-VI ternary compounds and other multinary compounds such as cadmium telluride (CdTe). Insulating oxide layers, may include SnO₂, CdSnO₄, ZnSnO₄,In₂O₃.

### BRIEF INTRODUCTION TO THE DRAWINGS

Figure 1 is a schematic cross sectional view of a type of solar cell according to the invention; and,
Figure 2 is a Light IV, current/voltage, curve for a cell of the invention.

The schematics of the solar cell structure are similar to that described in the above-mentioned patents and US-A-4,915,745 issued to Pollock on April 10, 1990, (reexamined and issued on April 7, 1992).

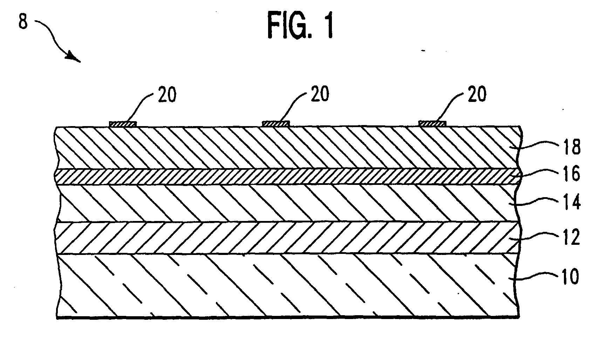

As shown schematically in Figure 1 of the drawings, the solar cell 8 is structurally supported on a glass substrate 10 having a thickness of approximately 1-4 mm. A back contact comprises a metal layer 12 of molybdenum having a thickness of approximately 0.2 microns deposited on substrate 10. The first semiconductor film 14 is p-type CIS having a thickness of approximately 1-3 microns having a thin layer 16 of chemically deposited insulating zinc oxide chemically deposited thereon from solution, as described below. The top layer 18 is substantially conductive, transparent, n-type CVD zinc oxide having a thickness of 0.1- 3.0 microns. Front face contacts or patterning 20 are optionally deposited on the exposed surface of layer 18. The techniques used in depositing such layers other than layer 16, together with a possible additional interfacial layer such as one of gallium (Ga) between the contact and the CIS, and the preferred methods of selenization of the CIS are described in the patents referred to above.

In initial developments on a test tube scale, zinc sulfate (ZnSO₄) solution was mixed with ammonium hydroxide (NH₄OH) and a precipitate of zinc hydroxide (Zn(OH)₂) formed. Further addition of ammonium hydroxide resulted in dissolution of the zinc hydroxide as a Zn/NH₄ complex formed. Dipping small pieces of CIS substrates in the test tube batches of Zn/NH₄ complex formed a layer of zinc hydroxide on their surfaces which, after optional drying with a stream of nitrogen, was then converted to zinc oxide through a dehydration step, by annealing the substrates in air at a temperature of approximately 230° C for about 10 minutes.

Using Auger electron spectroscopy (AES) analysis, it was determined that ZnO was deposited on the substrates.

Experiments also performed using zinc acetate (ZnAC₂) and triethanolamine(TEA) as an additional complexing agent led us to believe that, initially a solution of 0.01M ZnSO₄/0.7M NH₄OH and 55°C/5min dip time, then 0.01M ZnAC,/0.01M TEA/0.7M NH₄OH showed suitable promise as chemical solutions for larger scale (Benchtop Dip) experiments.

A subsequent series of benchtop scale experiments using 10x10cm CIS test substrates were performed.

A first experiment comparing test substrates dipped in solution concentrations of 0.01M ZnSO₄/0.7M NH₄OH at 55°C for 10 minutes, both with substrates also predipped for 30 min in ammonium hydroxide and with a cadmium sulfide control made by the conventional process described in the above patents, indicated that using zinc sulfate as the zinc salt for forming the zinc oxide film could form a reasonably good junction on CIS in place of the cadmium sulfide dip control, the zinc oxide layer cells being almost as good as the cadmium sulfide controls. However, predipping the substrates in 0.35M ammonium hydroxide for 30 minutes was found to affect, negatively, the Voc (open circuit voltage) and FF (fill factor) of the cells, resulting in lower efficiencies for that group than either the non-predipped or cadmium sulfide control groups.

A second experiment comparing substrates dipped in solution concentrations of 0.01M ZnAC₂/0.01M TEA/ 0.7M NH₄OH for 1 min at 55°C with both dipping in only ammonium hydroxide solution and with a cadmium sulfide control demonstrated that cells made with ZnAC₂/TEA/NH₄OH performed better than the cadmium sulfide controls with higher Voc being the main improvement for the zinc oxide group. The best cell efficiency of any zinc oxide layer CIS cell produced in this experiment was 12.9% efficiency, 467 mV.

A third experiment comparing substrates dipped in solution concentrations of 0.01M ZnAC₂/0.01M TEA/ 0.7M NH₄OH for 1 min at 55°C both with substrates dipped for 5 min at 55°C and with a cadmium sulfide control produced cells with higher Voc than in the second experiment. The 1 min/55°C zinc oxide layer group had a best cell Voc of 495 mV.

A further experiment demonstrated that a 5 min dip at the last mentioned concentration using sulfidized CIS cells indicated that zinc oxide layer cells had higher efficiency and V_{oc} than cadmium sulfide controls.

As a result of a further experiment comparing the effect of dipping for 5 minutes with the solution at room temperature with a typical 55°C dip (only the temperature was varied), the test substrate dipped at room temperature had a best cell Voc of 468 mV compared to 424 mV for the best cell dipped at 55°C.

However this was not confirmed by a subsequent experiment which indicated that the zinc oxide 55°C cell group was slightly better than the room temperature group and about comparable to a cadmium sulfide control. Possibly the results were affected by repeatedly using an old solution.

A further experiment comparing the performance of TEA/NH₄OH only solution with that of the ZnO dip baseline conditions ( 0.01M ZnAC₂/0.01M TEA/.64M NH₄OH) demonstrated that cells made without ZNAC₂ performed poorly, indicating that the formation of the ZnO layer is necessary for good performance.

We have also investigated the effect of the time and temperature of the dip process in two experiments. The first experiment, over the temperature range of 25 - 55°C, with dip times between 1 and 10 minutes, indicated performance is improved by reducing the dip temperature. The performance peaked around 45°C and 5 minutes but the trend in time and temperature was not very strong. The performance was in general, better than CdS controls.

However, the results of the second experiment in which the dip temperature was the main variable, were not confirmatory being, in general, lower and more scattered.

We believe from these experiments that the temperature of the dip solution can be reduced below the baseline 55°C, but that the performance is not a strong function of the dip time or bath temperature.

The effect of concentration of each of the chemicals, ZnAC₂., TEA and NH₄OH, in the ZnO dip bath was first explored by preparing small quantities in test tubes to observe the solution stability. The concentrations explored were the following:
ZnAC₂ and TEA - 0.001, 0.01 and 0.1M
NH₄OH 1.4, 0.64 and 0.35M
It appeared that the formation kinetics for the Zn/NH₃ and Zn/TEA complexes are rather slow in reaching equilibrium as the solubility product for Zn(OH)₂ is approached.

A further experiment compared the performance of cells dipped in solutions whose concentrations were selected from among those evaluated at a test tube scale. The results trend toward higher performance with increased concentration of all three chemicals. Cells dipped in 0.01M ZnAC₂/0.01M TEA/ 0.64M NH₄OH, and ZnAC₂ and TEA at 1M and NH₄OH at 1.4M produced higher efficiencies than CdS controls. This may be a practical limit on concentration of these three chemicals that can be used without forming free Zn(OH)₂ precipitate in the bath.

The parameters necessary to convert the Zn(OH)₂ layer deposited in the dip bath into zinc oxide were first studied using thermal analysis. Differential Scanning Calorimetry of Zn(OH)₂ indicated that there were two transitions in the temperature range of 23 - 240°C, one at 100°C due to evaporation of H₂O and the other at around 140°C due to the decomposition of the hydroxide to oxide.

Experiments to determine the results of annealing over the temperature range of 100 - 230°C for 5 - 15 minutes indicated that performance may peak around 180°C with the results varying as a function of time. At 100°C, performance trended downward with time but from 140°C up, the trend was toward better performance with increased time.

Experiments using patterned substrates for enabling the effect of interconnects on performance to be evaluated by comparing the performance of baseline operating conditions with that of CdS controls using the minimodule test structure scheme designed by K. Knapp (10/25/90, Procedures for Fabricating Post-Module Test Structures), revealed no significant difference between the performance of ZnO dip and CdS control parts.

Although the CIS has been contacted with the solution by dipping in a bath thereof it is envisaged that, in an alternative approach the solution may be sprayed on the CIS.

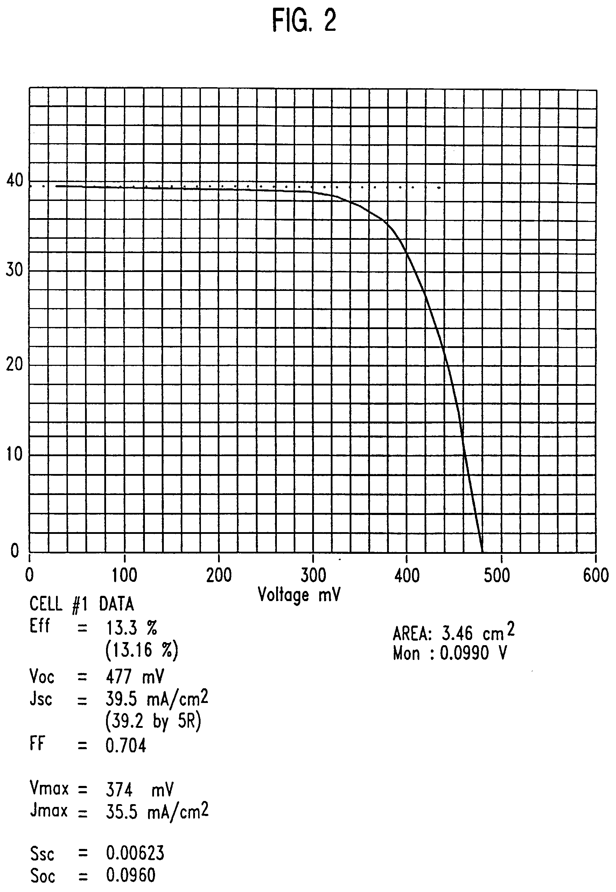

Figure 2 shows the Light IV curve for a 13.1% efficient cell formed from a dip concentration of 0.01M ZnAC₂/0.01M TEA/.7M NH₄OH

It will be apparent from the foregoing that highly efficient and, in some respects better performing, cells are produced by substituting a chemically deposited, zinc oxide layer, for the prior cadmium sulfide layer thereby affording the opportunity of obviating the risks associated with using highly toxic materials such as cadmium.

## Claims

1. A process for making a thin film heterojunction photovoltaic device comprising the steps of:
depositing a first multinary semiconductor film of a first conductivity type on a metal back contact;
chemically depositing from solution a thin film of a transparent, insulating metal oxide on said first semiconductor film; and
depositing a second, transparent metal oxide semiconductor film of conductivity type opposite said first type on said first semiconductor film,
wherein the film of transparent, insulating metal oxide is deposited by the steps of:
mixing a zinc salt with a suitable complexing agent to dissolve the zinc salt and form a zinc/ammonium (Zn/NH₄) complex in solution;
contacting, the first semiconductor film with the solution to deposit a thin film of zinc hydroxide from the solution on the first compound semiconductor film;
annealing the deposited zinc hydroxide film to convert the insulating zinc hydroxide to zinc oxide in air.

2. A process according to claim 1 in which the second semiconductor film is n-type zinc oxide.

3. A process according to claim 2, in which the first semiconductor film comprises copper indium diselenide.

4. A process according to claim 2 in which the zinc salt is one of zinc sulfate, zinc chloride and zinc acetate.

5. A process according to claim 4 wherein the complexing agent comprises ammonium hydroxide.

6. A process according to claim 5 wherein the zinc salt is zinc acetate and the complexing agent further comprises triethanolamine (TEA).

7. A process according to claim 6, wherein the solution comprises 0.001M to 0.1M zinc salt dissolved in 0.001M to 1.5M ammonium hydroxide.

8. A process according to claim 7 wherein the solution comprises 0.01M to 0.1M zinc salt dissolved in 0.1M to 1.5M ammonium hydroxide.

9. A process according to claim 8 wherein the solution comprises approximately 0.01M zinc salt dissolved in approximately 0.7M ammonium hydroxide.

10. A process according to claim 5 wherein the zinc salt is zinc sulfate.

11. A process according to claim 6 wherein the solution comprises 0.01M to 0.1M zinc acetate, 0.01M to 0.1M TEA and 0.6M to 1.5M ammonium hydroxide.

12. A process according to claim 11, wherein the solution comprises approximately 0.01M zinc acetate, 0.01M TEA and 0.64M ammonium hydroxide.

13. A process according to any one of claims 1-12, wherein for said second step of contacting the first compound semiconductor film, the solution has a bath temperature of 25 °C to 55 °C or about 20 °C.

14. A process according to any one of claims 1-13, wherein said second step of contacting the first compound semiconductor film with the solution takes between 1 min. and 10 min., preferably ca. 5 min.

15. A process according to any one of claims 1-14, wherein said third step of annealing is performed at a temperature between 140 °C and 230°C, preferably around 180 °C.

16. A process according to any of claims 1-15, wherein said third step of annealing takes between 5 min. and 15 min., preferably ca. 10 min.

## Revendications

1. Procédé pour réaliser un dispositif photovoltaïque en film mince à hétérojonction, comprenant les étapes consistant à :
déposer un premier film semi-conducteur multinaire d'un premier type de conductivité sur un contact arrière métallique; déposer chimiquement depuis une solution un film mince en un oxyde métallique isolant transparent sur ledit premier film semi-conducteur; et
à déposer un second film semi-conducteur en oxyde métallique transparent d'un type de conductivité opposé audit premier type sur ledit film semi-conducteur,
dans lequel le film en oxyde métallique isolant et transparent est déposé par les étapes consistant à :
mélanger un sel de zinc avec un agent complexant approprié pour dissoudre le sel de zinc et former un complexe zinc/ammonium (Zn/NH₄) en solution;
à mettre en contact le premier film semi-conducteur avec la solution pour déposer sur le premier film semi-conducteur, depuis la solution, un mince film d'hydroxyde de zinc; et
à chauffer dans l'air le film d'hydroxyde de zinc déposé pour convertir l'hydroxyde de zinc isolant en oxyde de zinc.

2. Procédé selon la revendication 1, dans lequel le second film semi-conducteur est un oxyde de zinc du type n.

3. Procédé selon la revendication 2, dans lequel le premier film semi-conducteur comprend du diséléniure de cuivre-indium.

4. Procédé selon la revendication 2, dans lequel le sel de zinc est choisi parmi le sulfate de zinc, le chlorure de zinc et l'acétate de zinc.

5. Procédé selon la revendication 4, dans lequel l'agent complexant comprend de l'hydroxyde d'ammonium.

6. Procédé selon la revendication 5, dans lequel le sel de zinc est l'acétate de zinc et l'agent complexant contient en outre de la triéthanolamine (TEA).

7. Procédé selon la revendication 6, dans lequel la solution contient un sel de zinc 0,001 M à 0,1 M dissous dans de l'hydroxyde d'ammonium 0,001 M à 1,5 M.

8. Procédé selon la revendication 7, dans lequel la solution contient un sel de zinc 0,01 M à 0,1 M dissous dans de l'hydroxyde d'ammonium 0,1 M à 1,5 M.

9. Procédé selon la revendication 8, dans lequel la solution contient un sel de zinc approximativement 0,01 M dissous dans de l'hydroxyde d'ammonium approximativement 0,7 M.

10. Procédé selon la revendication 5, dans lequel le sel de zinc est le sulfate de zinc.

11. Procédé selon la revendication 6, dans lequel la solution contient de l'acétate de zinc 0,01 M à 0,1 M, de la TEA 0,01 M à 0,1 M et de l'hydroxyde d'ammonium 0,6 M à 1,5 M.

12. Procédé selon la revendication 11, dans lequel la solution contient de l'acétate de zinc approximativement 0,01 M, de la TEA 0,01 M et de l'hydroxyde d'ammonium 0,64 M.

13. Procédé selon l'une quelconque des revendications 1 - 12, dans lequel, pour ladite seconde étape de mise en contact du premier film de composé semi-conducteur, la solution a une température de bain de 25 à 55 °C ou d'environ 20 °C.

14. Procédé selon l'une quelconque des revendications 1 - 13, dans lequel ladite seconde étape de mise en contact du premier film de composé semi-conducteur avec la solution est de 1 minute à 10 minutes et, de préférence, d'environ 5 minutes.

15. Procédé selon l'une quelconque des revendications 1 - 14, dans lequel ladite troisième étape de chauffage est effectuée à une température entre 140 °C et 230 °C et, de préférence, à environ 180 °C.

16. Procédé selon l'une quelconque des revendications 1 - 15, dans lequel ladite troisième étape de chauffage est d'environ 5 minutes à 15 minutes et, de préférence, d'environ 10 minutes.

## Patentansprüche

1. Prozeß zu Herstellung einer Dünnschicht-Photovoltaikvorrichtung mit Heteroübergang, umfassend die Schritte:
Abscheidung einer ersten multinären Halbleiterschicht eines ersten Leitfähigkeitstyps auf einem MetallRückkontakt;
chemische Abscheidung aus der Lösung einer dünnen Schicht eines transparenten, isolierenden Metalloxids auf die erste Halbleiterschicht; und
Abscheidung einer zweiten, transparenten Metalloxid-Halbleiterschicht eines Leitfähigkeitstyps, der dem ersten Typ entgegengesetzt ist, auf der ersten Halbleiterschicht,
wobei die Schicht aus transparentem, isolierendem Metalloxid abgeschieden wird durch die Schritte:
Mischen eines Zinksalzes mit einem geeigneten Komplexbildner, um das Zinksalz aufzulösen und einen Zink/Ammonium-Komplex (Zn/NH₄) in Lösung bilden;
Inkontaktbringen der ersten Halbleiterschicht mit der Lösung, um eine dünne Schicht von Zinkhydroxid aus der Lösung auf der ersten Halbleiterverbundschicht abzuscheiden;
Tempern der abgeschiedenen Zinkhydroxid-Schicht, um an Luft das isolierende Zinkhydroxid in Zinkoxid umzuwandeln.

2. Prozeß nach Anspruch 1, wobei die zweite Halbleiterschicht n-Typ Zinkoxid ist.

3. Prozeß nach Anspruch 2, wobei die erste Halbleiterschicht Kupfer-Indium-Diselenid umfaßt.

4. Prozeß nach Anspruch 2, wobei das Zinksalz Zinksulfat, Zinkchlorid oder Zinkacetat ist.

5. Prozeß nach Anspruch 4, wobei der Komplexbildner Ammoniumhydroxid umfaßt.

6. Prozeß nach Anspruch 5, wobei das Zinksalz Zinkacetat ist, und der Komplexbildner ferner Triethanolamin (TEA) umfaßt.

7. Prozeß nach Anspruch 6, wobei die Lösung 0,001M bis 0,1M Zinksalz aufgelöst in 0,001M bis 1,5M Ammoniumhydroxid umfaßt.

8. Prozeß nach Anspruch 7, wobei die Lösung 0,01M bis 0,1M Zinksalz aufgelöst in 0,1M bis 1,5M Ammoniumhydroxid umfaßt.

9. Prozeß nach Anspruch 8, wobei die Lösung ungefähr 0,01M Zinksalz aufgelöst in ungefähr 0,7M Ammoniumhydroxid umfaßt.

10. Prozeß nach Anspruch 5, wobei das Zinksalz Zinksulfat ist.

11. Prozeß nach Anspruch 6, wobei die Lösung 0,01M bis 0,1M Zinkacetat, 0,01M bis 0,1M TEA und 0,6M bis 1,5M Ammoniumhydroxid umfaßt.

12. Prozeß nach Anspruch 11, wobei die Lösung ungefähr 0,01M Zinkacetat, 0,01M TEA und 0,64M Ammoniumhydroxid umfaßt.

13. Prozeß nach einem der Ansprüche 1 bis 12, wobei die Lösung für den zweiten Schritt des Inkontaktbringens der ersten Verbundhalbleiterschicht eine Badtemperatur von 25°C bis 55°C oder ungefähr 20°C hat.

14. Prozeß nach einem der Ansprüche 1 bis 13, wobei der zweite Schritt des Inkontaktbringens der ersten Halbleiterverbundschicht mit der Lösung zwischen 1 und 10 Minuten, und vorzugsweise 5 Minuten dauert.

15. Prozeß nach einem der Ansprüche 1 bis 14, wobei der dritte Schritt des Temperns bei einer Temperatur zwischen 140°C und 230°C durchgeführt wird, vorzugsweise bei ungefähr 180°C.

16. Prozeß nach einem der Ansprüche 1 bis 15, wobei der dritte Schritt des Temperns zwischen 5 Minuten und 15 Minuten, vorzugsweise ungefähr 10 Minuten dauert.
